# EUROPÄISCHE PATENTSCHRIFT

(11) **EP 1 410 320 B1**
(45) Veröffentlichungstag und Bekanntmachung des Hinweises auf die Patenterteilung: **27.07.2005**
(21) Anmeldenummer: 00988596.3
(22) Anmeldetag: 16.11.2000
(51) Int. Cl.: G06K 19/077, H05K 3/46

(54) **VERFAHREN ZUR HERSTELLUNG EINER LEITERBAHNKREUZUNG AUF EINER DATENTRAGERKARTE**
METHOD FOR PRODUCTION OF A CONDUCTOR CROSS-OVER ON A DATA SUPPORT CARD
PROCEDE POUR LA PRODUCTION D'UN CROISEMENT DE PISTE CONDUCTRICE SUR UNE CARTE SUPPORT DE DONNEES

(30) Priorität: 24.11.1999 DE 19956436
(43) Veröffentlichungstag der Anmeldung: 21.04.2004
(73) Patentinhaber: Orga Kartensysteme GmbH, 33104 Paderborn (DE)
(72) Erfinder: SENGE, Carsten, 24105 Kiel (DE)
(86) Internationale Anmeldenummer: PCT/DE2000/003991
(87) Internationale Veröffentlichungsnummer: WO 2001/039114

(56) Entgegenhaltungen:
- DE-A- 19 512 272
- US-A- 4 440 823
- US-A- 4 962 287

## Beschreibung

Die Erfindung betrifft ein Verfahren zur Herstellung einer Datenträgerkarte, die einen Kartenkörper und mindestens eine im Kartenkörper angeordnete Leiterbahn mit mindestens einem Leiterbahnkreuzungspunkt und Leiterbahnanschlüssen aufweist.

Die beschriebenen Datenträgerkarten sind zumeist mit einem integrierten Schaltkreis in Form eines Chips ausgestattet und werden als so genannte Chipkarten in Form von Telefonkarten, Zugangsberechtigungskarten, Bankkarten usw. in steigendem Maße verwendet. Bei derartigen Karten erfolgt die Energieversorgung und der Datenaustausch der Karte mit externen Geräten über einen Berührungskontakt auf direktem Wege oder durch eine in die Karte eingebettete Spule auf induktivem Wege. Die für den induktiven Datenaustausch zuständige Spule wird üblicherweise gesondert auf einem Kunststofffilm aufgebracht und danach mit weiteren Kunststoffschichten zu einer fertigen Datenträgerkarte laminiert. Die fertigen Datenträgerkarten werden danach in einem abschließenden Fertigungsvorgang mit entsprechenden Druckbildern versehen. Die Herstellung derartiger Karten mittels eines Laminiervorganges hat sich zwar prinzipiell bewährt, ist jedoch aufgrund des relativ komplizierten Aufbaus derartiger Karten und der Komplexheit der dafür notwendigen Herstellungsmaschinen nicht sehr kostengünstig. Die Herstellung von Leiterplatten mit Leiterbahn-Kreuzungen ist allgemein bekannt (siehe z.B. DE-A-19512 272 oder US-A-4 962 287).

Aufgabe der vorliegenden Erfindung ist es daher, ein Verfahren zur Herstellung einer oben geschilderten Datenträgerkarte vorzustellen, welches kostengünstig mit einfach konzipierten Maschinen durchführbar ist.

Diese Aufgabe wird erfindungsgemäß durch die Verfahrensschritte der technischen Lehre des Anspruches 1 gelöst. Diese Verfahrensschritte sehen im Einzelnen vor, dass zunächst ein Kunststofflcartenkörperrohling hergestellt wird, auf dessen einer Flachseite die Leiterbahn mit den Leiterbahnanschlüssen aufgebracht wird, wobei die Leiterbahn im Bereich des Leiterbahnkreuzungspunktes Anschlusspunkte für eine Leiterbahnbrücke aufweist. In einem darauf folgenden Verfahrensschritt erfolgt das Aufbringen eines Isolierlackmaterials auf die nicht mit der Leiterbahn verdeckte Restfläche der Flachseite des Kunststoffkartenkörperrohlings dergestalt, dass die Stärke der Isolierlackschicht geringfügig geringer ist als die Dicke der Leiterbahn.

Anschließend wird im Bereich des Leiterbahnkreuzungspunktes zwischen den Anschlusspunkten für die Leiterbahnbrücke über der Leiterbahn gesondert ein Isolierlackmaterial aufgetragen. Über diesem Isolierlackmaterial wird dann anschließend eine Leiterbahnbrücke aus leitendem Lack zwischen den Anschlusspunkten aufgebracht, wobei die Anschlusspunkte leitend miteinander verbunden werden. Abschließend wird die gesamte Flachseite des Kunststoffkartenkörperrohlings mit einer Schutzschicht aus isolierendem Material versehen, wobei die Leiterbahnanschlüsse beispielsweise für die Einbringung eines Chipmoduls, ausgespart bleiben.

Vorteilhafte Ausgestaltungen des erfindungsgemäßen Verfahrens ergeben sich zusammen mit der technischen Lehre des Anspruches 1 aus den Merkmalen der Unteransprüche. Vorteilhaft ist insbesondere, den Kunststoffkartenkörperrohling in Spritzgussverfahren herzustellen, da dieses Verfahren große Stückzahlen bei niedrigen Stückkosten erlaubt. Darüber hinaus kann es zweckmäßig sein, bei den anschließenden Verfahrensschritten des Aufbringens des Isolierlackmaterials, der Leiterbahnbrücke sowie der abschließenden Schutzschicht das aus dem Stand der Technik hinlänglich bekannte Siebdruckverfahren einzusetzen. Alle genannten Verfahrensschritte lassen sich ohne Spezialrnaschinen mit herkömmlichen aus dem Stand der Technik bekannten Einrichtungen durchführen, so dass das Verfahren insgesamt als kostengünstig einzustufen ist.

Das oben geschilderte erfindungsgemäße Verfahren kann insbesondere auch dann eingesetzt werden, wenn der Spritzgusskartenkörperrohling bereits Ausnehmungen für elektronische Bauelemente wie beispielsweise ein Chipmodul, aufweist, da beim Aufbringen der einzelnen Materialschichten auf dem Kunststoffkartenkörperrohling die entsprechenden Bereiche problemlos durch entsprechende Gestaltung der Siebdruckschablone ausgespart bleiben können.

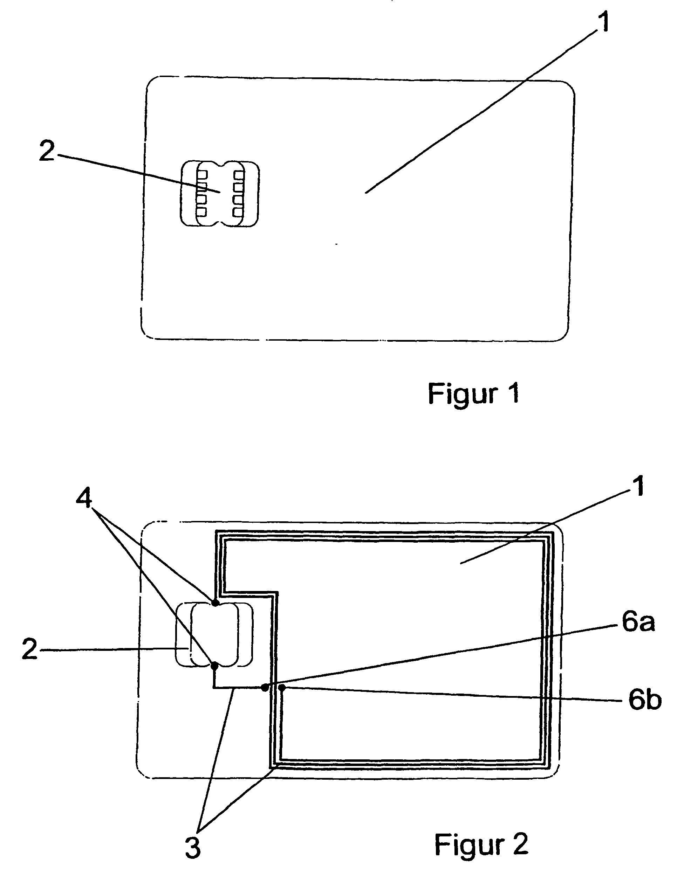

Im Folgenden werden anhand der beigefügten Zeichnungen die einzelnen Verfahrensschritte zur Herstellung einer Datenträgerkarte näher erläutert. Die Figuren 1 bis 6 zeigen hierbei Draufsichten auf diejenige Flachseite der Datenträger- oder Chipkarte, auf der die Leiterbahnen in Form einer Spule aufgebracht werden.

Hierbei ist in der Figur 1 zunächst der Kunststoffkartenkörperrohling 1 zu sehen, der im Spritzgussverfahren hergestellt wird und in den bereits eine Kavität 2 zur Aufnahme eines Chipmodul eingearbeitet ist.

Als nächster Verfahrensschritte erfolgt auf die mit der Kavität 2 versehene Flachseite des Kartenkörperrohlings 1 das Aufbringen von Leiterbahnen 3, wobei die Leiterbahnen zum einen mit Anschlussflächen 4 für die Verbindung zum einzusetzenden Chipmodul und darüber hinaus im Bereich eines Leiterbahnkreuzungspunktes 5 mit zusätzlichen Anschlusspunkten 6, welche seitlich der durchgehenden Leiterbahnen 3 angeordnet sind, versehen sind.

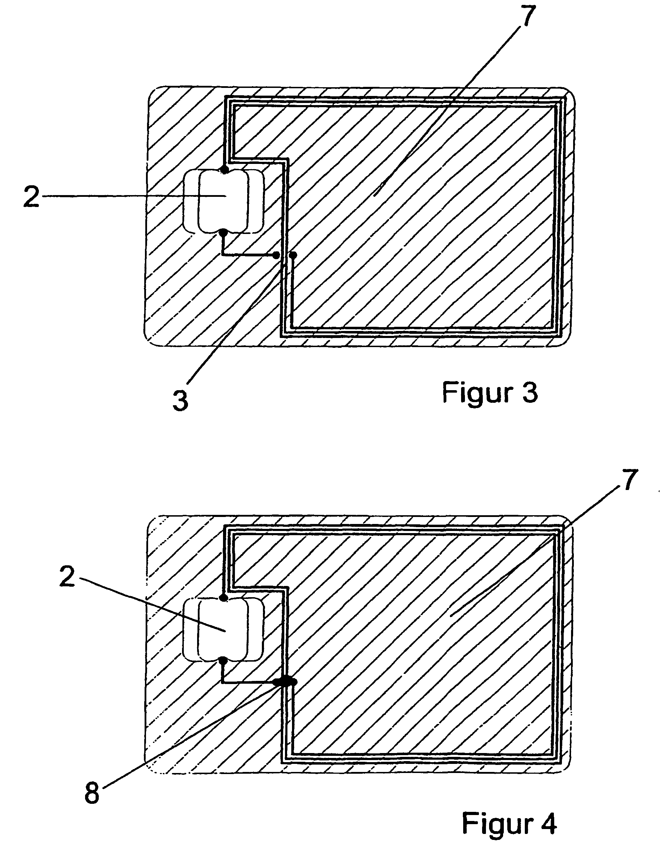

Die Darstellung der Figur 3 zeigt den Kartenkörperrohling 1 nach Abschluss des Verfahrensschrittes 3, in dem ein Isolierlackmaterial auf die nicht mit der Leiterbahn und den Anschlusspunkten sowie der Kavität bedeckte Restfläche der Flachseite des Kartenkörperrohlings aufgebracht wurde, dergestalt, dass die Stärke der Isolierlackschicht 7 geringfügig geringer ist als die Dicke der Leiterbahnen 3 sowie der Anschlussflächen 4 und Anschlusspunkte 6a und 6b.

Im anschließenden Verfahrensschritt wird zwischen die Anschlusspunkte 6a, 6b gesondert ein Isolierlackmaterial, beispielsweise als Punktfläche 8 aufgebracht.

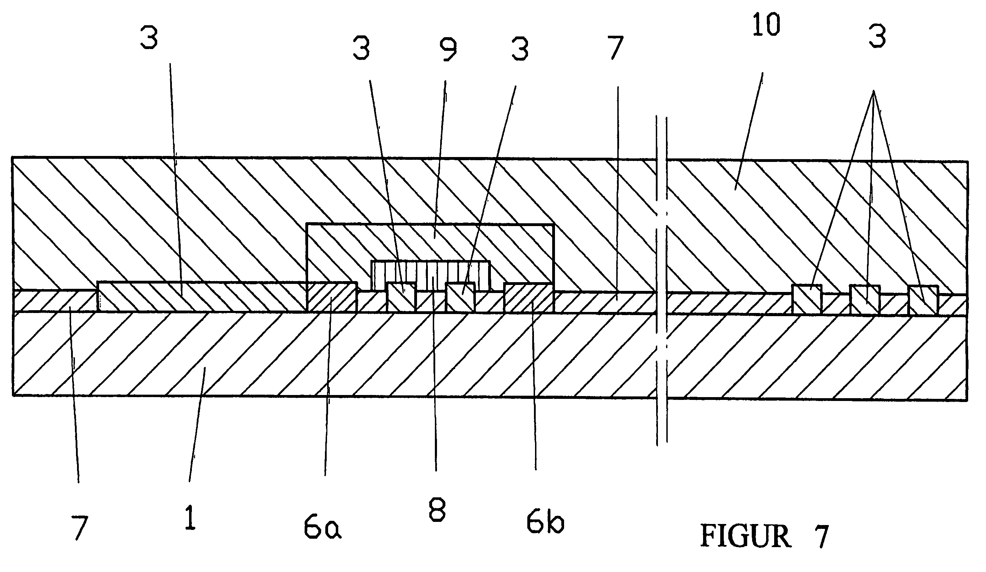

Die Punktfläche 8 aus Isoliermaterial überdeckt die zwischen den Anschlusspunkten 6a und 6b liegenden Leiterbahnen 3, wie diese auch aus der Schnittdarstellung der Figur 7 deutlich wird.

Über diese Punktfläche 8 aus Isolierlackmaterial wird anschließend im nächsten Verfahrensschritt aus elektrisch leitendem Material eine gesonderte Leiterbahn 9 aufgebracht, welche die Anschlussflächen 6a und 6b miteinander verbindet und somit im Bereich des Leiterbahnkreuzungspunktes 5 eine Leiterbahnbrücke schafft, so dass die auf dem Kunststoffkartenkörperrohling 1 aufzubringende Spule ihre endgültige Form erhält.

In einem abschließenden Verfahrensschritt wird die gesamte Flachseite des Kunststoffkartenkörperrohlings 1 mit einer abschließenden Schutzschicht 10 aus isolierendem Material versehen. Das isolierende Material kann vor dem Aufbringen auf die Flachseite des Kunststoffkartenkörperrohlings 1 entsprechend den Vorgaben des Datenträgerkartenbestellers farblich eingefärbt werden, so dass eine nachfolgende farbliche Gestaltung der Karte durch Aufbringen einer gesonderten Farbschicht entfallen kann.

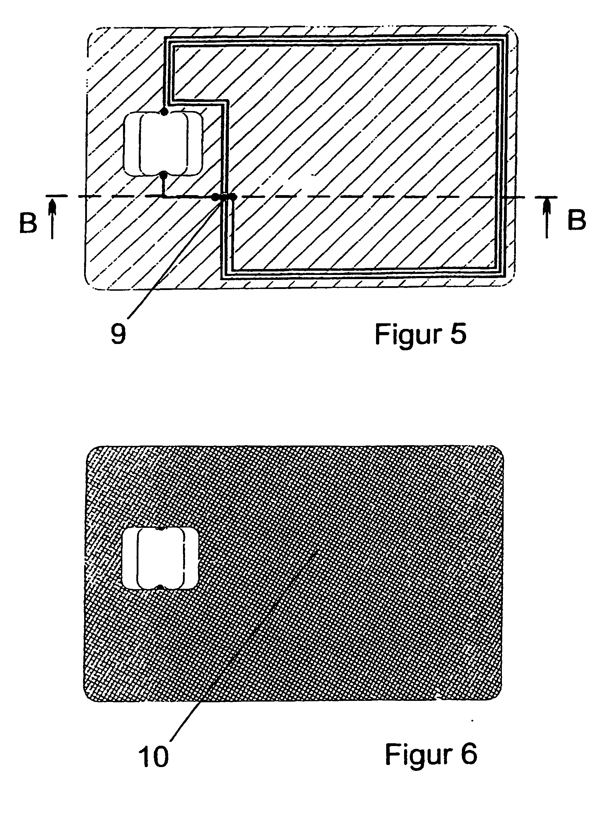

In der Figur 7 ist entsprechend der Schnittlinie B-B aus Figur 6 ein Querschnitt durch die fertige Datenträgerkarte dargestellt, wobei die einzelnen Leiterbahnen 3, die Anschlusspunkte 6a, 6b, die Isotierlackschicht 7, die Punktfläche 8 sowie die als Leiterbahnbrücke gestaltete gesonderte Leiterbahn 9 und die abschließende Schutzschicht 10 in ihrer Anordnung auf dem Datenträgerkartenkörperrohling 1 noch einmal deutlich wird.

### Bezugszeichenliste

- 1: Kunststoffkartenkörperrohling
- 2: Kavität
- 3: Leiterbahn
- 4: Anschlussfläche
- 5: Leiterbahnkreuzungspunkt
- 6a: Anschlusspunkt
- 6b: Anschlusspunkt
- 7: Isolierlackschicht
- 8: Punktfläche
- 9: Leiterbahnbrücke
- 10: Schutzschicht

## Patentansprüche

1. Verfahren zur Herstellung eines Kartenkörpers für eine Datenträgerkarte mit mindestens einer im Kartenkörper angeordneten Leiterbahn mit mindestens einem Leiterbahnkreuzungspunkt und Leiterbahnanschlüssen, mit den folgenden Verfahrensschritten.
- Herstellung eines Kunststoffkartenkörperrohlings (1)
- Aufbringen der Leiterbahn (3) mit den Leiterbahnanschlussflächen (4) auf mindestens einer Flachseite des Kunststoffkartenkörperrohlings (1), wobei die Leiterbahn (3) im Bereich des Leiterbahnkreuzungspunktes (5) Anschlusspunkte (6a, 6b) für eine Leiterbahnbrücke (9) aufweist,
- Aufbringen eines Isolierlackmateriats (7) auf die nicht mit der Leiterbahn (3) bedeckte Restfläche der Flachseite des Kunststoffkartenkörperrohlings (1) dergestalt, dass die Stärke der Isolierlackmaterialschicht (7) geringfügig geringer ist als die Dicke der Leiterbahn (3), der Anschlussflächen (4) sowie der Anschlusspunkte (6a, 6b),
- Aufbringen eines Isolierlackmaterials im Bereich des Leiterbahnkreuzungspunktes (5) zwischen den Anschlusspunkten (6a, 6b) für die Leiterbahnbrücke (9),
- Aufbringen der Leiterbahnbrücke (9) aus leitendem Lackmaterial zwischen den Anschlusspunkten (6a, 6b), wobei die Anschlusspunkte (6a, 6b) leitend miteinander verbunden werden,
- Aufbringen einer Schutzschicht (10) aus isolierendem Material auf der mit der Leiterbahn (3), den Anschlussflächen (4) sowie den Anschlusspunkten (6a, 6b) versehenen Flachseite des Kunststoffkartenkörperrohlings (1), wobei die Leiterbahnanschlüsse ausgespart bleiben.

2. Verfahren nach Anspruch 1, **dadurch gekennzeichnet, dass** der Kunststoffkartenkörperrohling (1) im Spritzgussverfahren hergestellt wird.

3. Verfahren nach Anspruch 1 oder 2, **dadurch gekennzeichnet, dass** die Isolierlackschicht (7) aus Isolierlackmaterial im Siebdruckverfahren aufgebracht wird.

4. Verfahren nach einem der Ansprüche 1 bis 3, **dadurch gekennzeichnet, dass** die Leiterbahnbrücke (9) zwischen den Anschlusspunkten 6a, 6b im Siebdruckverfahren aufgetragen wird.

5. Verfahren nach einem der Ansprüche 1 bis 4, **dadurch gekennzeichnet, dass** dass die Schutzschicht aus isolierendem Material (10) auf der mit der Leiterbahn (3) und den Anschlussflächen (4) versehenen Flachseite des Kunststoffkartenkörperrohlings (1) im Siebdruckverfahren aufgebracht wird.

6. Verfahren nach einem der Ansprüche 1 bis 5, **dadurch gekennzeichnet, dass** die Schutzschicht (10) vor dem Aufbringen auf die Flachseite des Kunststoffkartenkörperrohlings (1) farbig eingefärbt wird.

## Claims

1. Method for the production of a card body for a data support card which has arranged in the card body at least one conductor with at least one conductor cross-over point and conductor connectors, having the following method steps:
- production of a plastic card body blank (1);
- application of the conductor (3) with the conductor connection surfaces (4) to at least one flat side of the plastic card body blank (1), wherein the conductor (3) has connector points (6a, 6b) for a conductor bridge (9) in the region of the conductor cross-over point (5);
- application of an insulating coating material (7) to the remaining surface of the flat side of the plastic card body blank (1) which is not covered by the conductor (3), in such a way that the thickness of the insulating coating material layer (7) is fractionally less than the thickness of the conductor (3), the connection surfaces (4) and the connector points (6a, 6b);
- application of an insulating coating material in the region of the conductor cross-over point (5) between the connector points (6a, 6b) for the conductor bridge (9);
- application of the conductor bridge (9) made of a conductive coating material between the connector points (6a, 6b), whereby the connector points (6a, 6b) are conductively connected to each other;
- application of a protective layer (10) made of an insulating material to the flat side of the plastic card body blank (1) which carries the conductor (3), the connection surfaces (4) and the connector points (6a, 6b), wherein the conductor connectors remain exposed.

2. Method according to Claim 1, **characterized in that** the plastic card body blank (1) is produced using an injection molding technique.

3. Method according to Claim 1 or 2, **characterized in that** the insulating coating layer (7) made of insulating coating material is applied using the screen printing technique.

4. Method according to one of Claims 1 to 3, **characterized in that** the conductor bridge (9) between the connector points (6a, 6b) is applied using the screen printing technique.

5. Method according to one of Claims 1 to 4, **characterized in that** the protective layer made of insulating material (10) is applied to the flat side of the plastic card body blank (1) which carries the conductor (3) and the connection surfaces (4) using the screen printing technique.

6. Method according to one of Claims 1 to 5, **characterized in that** the protective layer (10) is colored prior to application to the flat side of the plastic card body blank (1).

## Revendications

1. Procédé pour la fabrication d'un corps de carte pour une carte de support de données, avec au moins une piste conductrice, disposée dans le corps de carte, avec au moins un point de croisement de piste conductrice et avec des raccords de piste conductrice, lequel procédé comprend les étapes suivantes:
- Fabrication d'une ébauche (1) de corps de carte en matière plastique,
- Application de la piste conductrice (3), avec les raccords de piste conductrice (4), sur au moins une face plane de l'ébauche (1) de corps de carte en matière plastique, la piste conductrice (3) présentant, dans le domaine du point de croisement de piste conductrice (5), des points de raccordement (6a, 6b) pour un pont de piste conductrice (9),
- Applilcation d'une laque isolante (7) sur le reste de la surface plane de l'ébauche (1) de corps de carte en matière plastique non recouvert par la piste conductrice (3), de manière à ce que l'épaisseur de la couche de la laque isolante (7) soit légèrement inférieure à l'épaisseur de la piste conductrice (3), des surfaces de raccordement (4) ainsi que des points de raccordement (6a, 6b),
- Application d'une laque isolante, dans la section des points de croisement de piste conductrice (5), entre les points de raccordement (6a, 6b) pour le pont de piste conductrice (9),
- Application du pont de piste conductrice (9) en laque conductrice entre les points de raccordement (6a, 6b), lesdits points de raccordement (6a, 6b) étant reliées ensemble de manière conductrice..
- Application d'une couche protectrice (10) en matière isolante, sur la face plane de l'ébauche de corps de carte en matière plastique (1), pourvue de la piste conductrice (3), des surfaces de raccordement (4) ainsi que des points de raccordement (6a, 6b), les raccords de pistes conductrices demeurant épargnés.

2. Procédé selon la revendication 1, **caractérisé en ce que** l'ébauche de corps de carte en matière plastique (1) est fabriqué selon le procédé de moulage par injection.

3. Procédé selon la revendication 1 ou 2, **caractérisé en ce que** la couche de laque isolante (7) est appliquée par sérigraphie..

4. Procédé selon l'une des revendications 1 à 3, **caractérisé en ce que** le pont de piste conductrice (9) est appliqué, entre les points de raccordement 6a, 6b, par sérigraphie.

5. Procédé selon l'une des revendications 1 à 4, **caractérisé en ce que** la couche protectrice en matière isolante (10) est appliquée par sérigraphie, sur la face plane de l'ébauche de corps de carte en matière plastique (1) qui est pourvue de la piste conductrice (3) et des surfaces de raccordement (4).

6. Procédé selon l'une des revendications 1 bis 5, **caractérisé en ce que** la couche protectrice (10) est colorée avant l'application sur la face plane de l'ébauche de corps de carte en matière plastique (1).
